Europäisches Patentamt

European Patent Office

Office européen des brevets

(19)

(11) **EP 0 441 201 B1**

(12) **EUROPEAN PATENT SPECIFICATION**

(45) Date of publication and mention
of the grant of the patent:
**15.05.1996  Bulletin 1996/20**

(51) Int Cl.⁶: **G05F 3/20**, G11C 5/14,
G11C 7/00

(21) Application number: **91100961.1**

(22) Date of filing: **25.01.1991**

(54) **A substrate bias voltage detection circuit**

Substratvorspannung Detektorschaltung

Circuit détecteur de la tension de polarisation du substrat

(84) Designated Contracting States:
**DE FR GB IT NL**

(30) Priority: **05.02.1990  US 475061**

(43) Date of publication of application:
**14.08.1991  Bulletin 1991/33**

(73) Proprietor: **TEXAS INSTRUMENTS
INCORPORATED
Dallas Texas 75265 (US)**

(72) Inventors:
• **Tsay, Ching-Yuh
  Richardson, Texas 75082 (US)**
• **Iyengar, Narasimhan
  Plano, Texas 75093 (US)**

(74) Representative: **Leiser, Gottfried, Dipl.-Ing. et al
Prinz & Partner,
Manzingerweg 7
D-81241 München (DE)**

(56) References cited:
**EP-A- 0 222 472          WO-A-81/02359
US-A- 4 794 278          US-E- 32 200**

• **PATENT ABSTRACTS OF JAPAN vol. 11, no. 340
(P-634)7 November 1987 & JP-A-62 121 996 (
HITACHI LTD ) 3 June 1987**

**Description**

This invention is in the field of integrated circuits, and more specifically is directed to circuits for detecting the level of a substrate bias voltage.

Background of the Invention

Many modern integrated circuits are fabricated according to complementary-metal-oxide-semiconductor (CMOS) technology, where both p-channel and n-channel MOS transistors are formed in the same semiconductor chip. CMOS technology provides good performance together with much reduced power consumption, as compared with other technologies such as bipolar and n-channel MOS. As is well known, however, CMOS structures have present a parasitic thyristor, or SCR, formed by alternating p-type and n-type structures. If the CMOS integrated circuit is exposed to a voltage which is above the firing voltage of the parasitic SCR, a latchup condition can occur. Once the structure is in latchup, destructive amounts of current can be drawn through the SCR, often damaging the integrated circuit.

Many techniques for reducing the tendency of latchup for a given integrated circuit have been utilized. One such technique is the provision of a substrate bias which is more negative than the ground, or common, potential provided to the integrated circuit. Of course, such negative substrate bias is also useful for other reasons, such as improving the performance of the integrated circuit by raising the threshold voltage of enhancement-mode n-channel MOS transistors. However, the presence of the negative substrate bias can ensure that the base-emitter junction of one of the parasitic bipolar transistors in the parasitic SCR does not become forward-biased for reasonable excursions of voltages applied to the integrated circuit. Without the forward-biased condition at the base-emitter junction of the parasitic bipolar transistor, latchup by way of the parasitic SCR cannot occur.

Such negative substrate bias can be provided by way of a voltage applied to the integrated circuit chip from an external power supply; the necessity for such an external power supply is not favored by many integrated circuit users, due to the increase in the system cost required to provide such a power supply. Accordingly, a preferred way of providing substrate bias at a voltage more negative than the chip ground potential is by way of a charge pump. Examples of charge pump circuits for providing substrate bias are described in U.S. Patent No. 4,585,954, issued April 29, 1986, U.S. Patent No. 4,628,215, issued December 9, 1986, and in U.S. Patent No. 4,631,421, issued December 23, 1986, all assigned to Texas Instruments Incorporated and incorporated herein by this reference. Whether the substrate bias is applied from external to the chip or generated on-chip, if the substrate bias is lost for some reason, the integrated circuit can become vulnerable to the latchup condition.

The problem of substrate bias voltage detection has been addressed in EP-A-0 222 472. The deflecting circuit disclosed therein compares the substrate voltage against a reference voltage. The present invention does not require a reference voltage. Similarly, US-A-4,794,278 discloses a different substrate bias voltage detection unit. The disclosed unit has a larger number of components, has a different structure and functions in a manner different from the substrate bias voltage detector of the present invention.

It is therefore an object of this invention to provide a circuit which can detect the loss of proper substrate bias.

It is a further object of this invention to provide such a circuit on-chip with a VLSI integrated circuit.

It is a further object of this invention to provide such a circuit where the level at which substrate bias is detected does not strongly depend upon transistor sizes or channel width/length ratios.

Other objects and advantages of the invention will be apparent to those of ordinary skill in the art having reference to the following specification together with the drawings.

Summary of the Invention

According to the invention these objects are achieved by means of a circuit as defined in claim 1.

The output from the detection circuit can be used to disable other on-chip circuitry, including on-chip voltage regulator/drivers. In this way, the risk of latchup for much of the integrated circuit in the event of a loss of substrate bias can be reduced.

Brief Description of the Drawings

Figure 1 is an electrical diagram, in schematic form, of a substrate bias detection circuit according to the preferred embodiment of the invention.

Figure 2 is a transfer characteristic of the circuit of Figure 1.

Detailed Description of the Preferred Embodiment

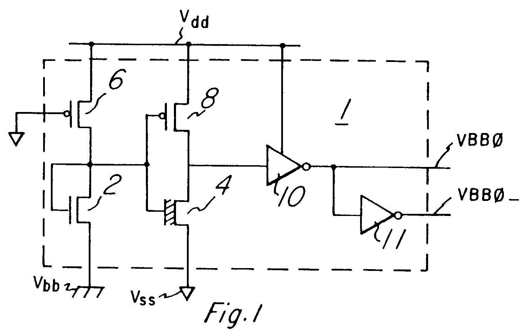

Referring to Figure 1, the construction of a bias voltage detection circuit 1 according to the preferred embodiment of the invention will be described in detail. Detection circuit 1 receives as inputs the voltage to be detected and bias voltages. In this example, the voltage to be detected is the substrate bias voltage $V_{bb}$, which is received at the source of transistor 2. The bias voltages include, in this example, the positive power supply voltage $V_{dd}$, and a common, or ground, potential $V_{ss}$. In this example, the desired potential of the substrate bias $V_{bb}$ is below $V_{ss}$ (for example, at a level on the order of -2.0 volts). As is well known in the art for conventional CMOS structures, such negative substrate bias is useful in reducing the susceptibility of the parasitic SCR in the CMOS structure from entering a latchup condition. Detection circuit 1 has an output, on line VBB0, which is at a high logic level when the substrate bias $v_{bb}$ is at a potential above $V_{ss}$, and is at a low logic level when the substrate bias $V_{bb}$ is below $_{Vss}$. As will be described hereinbelow, the signal generated by detection circuit 1 on line VBB0 can be used to shut down other circuits on the same integrated circuit chip to avoid such other circuits from entering a latchup state in the absence of sufficient substrate bias.

In detection circuit 1, n-channel transistor 2 has its source connected to the substrate node $V_{bb}$. The gate of transistor 2 is connected to its drain, and both are connected to the drain of a p-channel transistor 6. P-channel transistor 6 has its source connected to $V_{dd}$, and its gate biased to $V_{ss}$, and thus presents a pull-up load to transistor 2. The drains of transistors 2 and 6 are connected to the gates of n-channel transistor 4 and p-channel transistor 8. N-channel transistor 4 and p-channel transistor 8 are connected in inverter fashion, with the source of n-channel transistor 4 biased to $V_{ss}$. The source of p-channel load transistor 8 is biased to $V_{dd}$, and the drains of transistors 4 and 8 are connected together. Inverter 10 has its input connected to the drains of transistors 4 and 8, and its output drives line VBB0, presenting the output of detection circuit 1 with the desired logic scheme (i.e., line VBB0 indicating the absence of sufficient substrate bias with a high logic level). Inverter 11 has its input connected to the output of inverter 10, and presents a signal on line VBB0_ which is the logical complement of the signal on line VBB0, and thus indicates loss of $V_{bb}$ with a low logic level.

It is desirable that the potential of $V_{bb}$ at which detection circuit 1 issues a loss-of-$V_{bb}$ signal on line VBB0 be at some level below $V_{ss}$. This ensures that the remainder of the integrated circuit is disabled well prior to such time as the substrate reaches the voltage at which the base-emitter junction of one of the transistors in the parasitic SCR is forward biased. The detection voltage is preferably close to $V_{ss}$, so that detection circuit 1 will thus only respond to those conditions for which latchup can occur, and will tend not to respond to noise and other transient conditions which can often occur in large scale integrated circuits. The level at which detection circuit 1 trips is set in this embodiment by the difference in threshold voltages between transistors 2 and 4. In this embodiment, transistor 2, to which $V_{bb}$ is connected, has a higher threshold voltage than transistor 4, to which $V_{ss}$ is connected. For example, the threshold voltage $V_{t2}$ of transistor 2 can be on the order of +0.8 volts (measured at $V_{bb}$ of -2.0 volts) and the threshold voltage $V_{t4}$ of transistor 4 can be on the order of +0.5 volts (measured at $V_{bb}$ of -2.0 volts), establishing a difference therebetween on the order of 0.3 volts.

In operation, p-channel load transistor 6 is in the on-state, due to its gate biased to $V_{ss}$, which biases the gate and drain of transistor 2 into the on-state also. It is preferable that transistor 2 have a much larger width-to-length (W/L) ratio than transistor 6, so that with both transistors in the on-state, the DC current drawn through transistors 2 and 6 is minimal. For example, the W/L ratio of n-channel transistor 2 may be on the order of 100, and the W/L ratio of p-channel transistor 6 may be on the order of 0.005. The voltage at the drains of transistor 2 and 6 will thus be pulled low through transistor 2, until it reaches a level at which transistor 2 turns off. This is approximately at a threshold voltage $V_{t2}$ above $V_{bb}$. Accordingly, the voltage at the gates of transistors 4 and 8 is approximately at $V_{bb} + V_{t2}$.

The voltage $V_{bb} + V_{t2}$ is sufficiently low, in this embodiment, to turn on p-channel transistor 8. Transistor 8 preferably has a small W/L ratio, compared to transistor 4; for example, transistor 8 may have a W/L ratio on the order of 0.05, with the W/L ratio of transistor 4 on the order of 20. Transistor 4 will, of course, turn on when its gate voltage is at a level greater than its threshold voltage $V_{t4}$ above $V_{ss}$. Since the voltage at the gate of transistor 4 is at $V_{bb} + V_{t2}$, transistor 4 turns on when the following inequality is satisfied:

$$(V_{bb} + V_{t2}) - V_{ss} > V_{t4}$$

which is equivalent to:

$$V_{bb} - V_{ss} > V_{t4} - V_{t2}$$

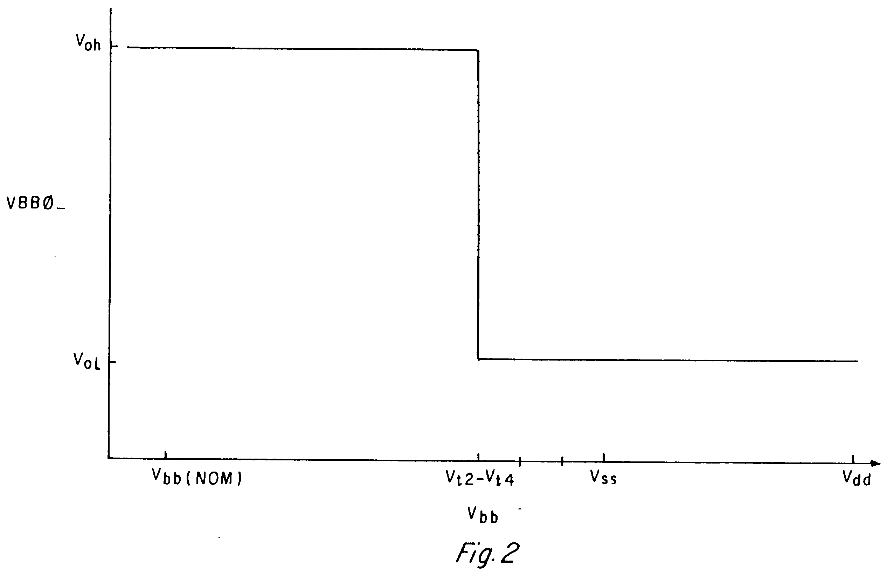

Figure 2 shows the DC transfer characteristic of substrate bias detection circuit 1 shown in Figure 1. As is shown in Figure 2, at the nominal $V_{bb}$ bias $V_{bb}(NOM)$, which is well below $V_{ss}$ (e.g., at -2.0 volts), line VBB0_ is at a high logic level, indicating adequate substrate bias. The trip point of the circuit is at the value $V_{t4} - V_{t2}$, as described above. Below this voltage for $V_{bb}$, line VBB0_ is at a high logic level; above this voltage, circuit 1 operates to present a low logic level on line VBB0_ at the output of inverter 11. Of course, the logic state on line VBB0_ at the output of inverter 10 is complementary to the logic state on line VBB0_ shown in Figure 1.

In the example of detection circuit 1 described hereinabove, where $V_{t2}$ is greater than $V_{t4}$ by 300 mV, transistor 4 will turn on when $V_{bb}$ is approximately at a value of -0.3 volts ($V_{ss}$ = 0.0 volts). Since transistor 4 is significantly larger than transistor 8, the drains of transistors 4 and 8, and thus the input to inverter 10, will be pulled low to $V_{ss}$ by transistor 4. A high logic level will, in turn, be presented by inverter 10 on line VBB0 at its output, and a low logic level will be presented by inverter 11 on line VBB0_ at its output.

## Claims

1. A substrate bias detection circuit of the type comprising a first transistor (2) having its source coupled to a substrate potential and having its drain and gate coupled to a drive node; a first load transistor (6) connected between said drive node and a bias potential; and a second transistor (4) having its source coupled to a common potential, having its gate coupled to said drive node, and having a drain, characterized in that

a second load transistor (8) is connected in inverter fashion to said second transistor, said second load transistor connected between the drain of said second transistor (4) and said bias potential, said gate terminal of said second load transistor coupled to said drive node; and wherein said first load resistor (6) has a gate terminal coupled to the common potential.

2. The detection circuit of claim 1, wherein said first and second transistors (2, 4) have different threshold voltages.

3. The detection circuit of claim 2, wherein the threshold voltage of said first transistor (2) is higher than the threshold voltage of said second transistor (4).

4. The detection circuit of claim 1, further comprising: a buffer circuit (10) connected to the drain of said second transistor (4).

5. The detection circuit of claim 4, wherein said buffer circuit (16) comprises an inverter.

6. The detection circuit of claim 1, wherein said first and second transistors (2, 4) are of a first conductivity type; and wherein said first load transistor (6) is of a second conductivity type between said drive node and said bias potential, and having its gate coupled to a potential in such a manner that the source/drain path is conductive responsive to said first transistor being conductive.

7. The detection circuit of claim 1, wherein said first and second transistors (2, 4) are of a first conductivity type; and wherein said second load transistor (8) is of a second conductivity type having its gate coupled to the gate of said second transistor (4).

**Patentansprüche**

1. Schaltung zur Substratvorspannungserfassung mit einem ersten Transistor (2), dessen Source-Anschluß an ein Substratpotential gelegt ist und dessen Drain- und Gate-Anschlüsse mit einem Ansteuerschaltungspunkt verbunden sind, einem ersten Lasttransistor (6), der zwischen dem Ansteuerschaltungspunkt und einem Vorspannungspotential angeschlossen ist, dessen Gate-Anschluß mit dem Ansteuerschaltungspunkt verbunden ist und der einen Drain-Anschluß aufweist, dadurch gekennzeichnet, daß ein zweiter Lasttransistor (8) nach Art eines Inverters mit dem zweiten Transistor verbunden ist, wobei der zweite Lasttransistor zwischen dem Drain-Anschluß des zweiten Transistors (4) und das Vorspannungspotential geschaltet ist, wobei der Gate-Anschluß des zweiten Lasttransistors mit dem Ansteuerschaltungspunkt verbunden ist, und wobei ein Gate-Anschluß des ersten Lasttransistors (6) an das gemeinsame Potential gelegt ist.

2. Erfassungsschaltung nach Anspruch 1, bei welcher der erste und der zweite Transistor (2, 4) unterschiedliche Schwellenspannungen haben.

3. Erfassungsschaltung nach Anspruch 2, bei welchem die Schwellenspannung des ersten Transistors (2) höher als die Schwellenspannung des zweiten Transistors (4) ist.

4. Erfassungsschaltung nach Anspruch 1, ferner enthaltend eine Pufferschaltung (10), die mit dem Drain-Anschluß des zweiten Transistors (4) verbunden ist.

5. Erfassungsschaltung nach Anspruch 4, bei welchem die Pufferschaltung (10) ein Inverter ist.

6. Erfassungsschaltung nach Anspruch 1, bei welcher der erste und der zweite Transistor (2, 4) Transistoren eines ersten Leitfähigkeitstyps sind und bei welcher der erste Lasttransistor (6) ein Transistor eines zweiten Leitfähigkeitstyps zwischen dem Ansteuerschaltungspunkt und dem Vorspannungspotential ist, dessen Gate-Anschluß derart an ein Potential gelegt ist, daß die Source/Drain-Strecke abhängig vom leitenden Zustand des ersten Transistors leitend ist.

7. Erfassungsschaltung nach Anspruch 1, bei welcher der erste und der zweite Transistor (2, 4) Transistoren eines ersten Leitfähigkeitstyps sind und bei welcher der zweite Lasttransistor (8) ein Transistor eines zweiten Leitfähigkeitstyps ist, dessen Gate-Anschluß mit dem Gate-Anschluß des zweiten Transistors (4) verbunden ist.

**Revendications**

1. Circuit de détection de la polarisation d'un substrat du type comprenant un premier transistor (2) ayant sa source connectée à un potentiel de substrat et ayant ses drain et grille couplés à un noeud de commande ; un premier transistor de charge (6) connecté entre lesdits noeuds de commande et potentiel de polarisation; et un deuxième transistor (4) ayant sa source couplée à un potentiel commun, ayant sa grille couplée audit noeud de commande, et ayant un drain, caractérisé en ce qu'il comporte un deuxième transistor de charge (8) connecté en inverse audit deuxième transistor, ledit deuxième transistor de charge étant connecté entre le drain dudit deuxième transistor (4) et ledit potentiel de polarisation, ladite borne de grille dudit deuxième transistor de charge étant couplée audit noeud de commande; et dans lequel ledit premier transistor de charge (6) comporte une borne de grille couplée au potentiel commun.

2. Circuit de détection selon la revendication 1, dans lequel lesdits premier et deuxième transistors (2,4) comportent des tensions de seuil différentes.

3. Circuit de détection selon la revendication 2, dans lequel la tension de seuil du premier transistor (2) est supérieure à la tension de seuil dudit deuxième transistor (4).

4. Circuit de détection selon la revendication 1, comprenant en outre :
   un circuit tampon (10) connecté au drain dudit deuxième transistor (4).

5. Circuit de détection selon la revendication 4, dans lequel ledit circuit tampon (10) comporte un inverseur.

6. Circuit de détection selon la revendication 1, dans lequel lesdits premier et deuxième transistors (2,4) sont d'un premier type de conductivité ; et dans lequel ledit premier transistor de charge (6) est d'un deuxième type de conductivité entre ledit noeud de commande et ledit potentiel de polarisation, et ayant sa grille couplée à un potentiel de sorte que le trajet source/-drain est conducteur lorsque ledit premier transistor est conducteur.

7. Circuit de détection selon la revendication 1, dans lequel lesdits premier et deuxième transistors (2,4) sont d'un premier type de conductivité ; et dans lequel ledit deuxième transistor de charge (8) est d'un deuxième type de conductivité ayant sa grille couplée à la grille dudit deuxième transistor (4).

Fig.1

EP 0 441 201 B1

*Fig. 2*